(19) **Europäisches Patentamt / European Patent Office / Office européen des brevets**

(11) **EP 4 614 202 A1**

(12) **EUROPEAN PATENT APPLICATION**
published in accordance with Art. 153(4) EPC

(43) Date of publication:
10.09.2025 Bulletin 2025/37

(21) Application number: 23885328.7

(22) Date of filing: 10.08.2023

(51) International Patent Classification (IPC):
$G02B\ 6/46$ (2006.01)   $G02B\ 6/42$ (2006.01)
$H01S\ 5/02251$ (2021.01)   $H01S\ 5/02326$ (2021.01)

(52) Cooperative Patent Classification (CPC):
G02B 6/42; G02B 6/46; H01S 5/02251;
H01S 5/02326

(86) International application number:
PCT/JP2023/029219

(87) International publication number:
WO 2024/095556 (10.05.2024 Gazette 2024/19)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 02.11.2022 JP 2022176000

(71) Applicant: FUJIKURA LTD.
Koto-ku
Tokyo 135-8512 (JP)

(72) Inventor: TABATA, Yoshihiro
Sakura-shi, Chiba 285-8550 (JP)

(74) Representative: Bardehle Pagenberg
Partnerschaft mbB
Patentanwälte Rechtsanwälte
Prinzregentenplatz 7
81675 München (DE)

(54) **FIBER RETENTION STRUCTURE AND LASER MODULE**

(57) The present invention provides a fiber retention structure that prevents heat generation due to light that has not been coupled to an optical fiber. A fiber retention structure 30 has an optical fiber 20 including a front end 21, a first fixation portion 22 located behind the front end 21, and an intermediate portion 23 located between the front end 21 and the first fixation portion 22, a ferrule 40 having a fiber retention hole 41 formed therein for retaining the first fixation portion 22 of the optical fiber 20, an adhesive material 60 that fixes the first fixation portion 22 of the optical fiber 20 in the fiber retention hole 41 of the ferrule 40, and a protection member 50 surrounding the ferrule 40. The protection member 50 includes a support portion 51 covering a circumference of the ferrule 40 and a shield portion 52 covering a front surface 40A of the ferrule 40 and having a fiber insertion hole 53 formed therein. The intermediate portion 23 of the optical fiber 30 is inserted in the fiber insertion hole 53.

Fig. 2

## Description

## Technical Field

The present invention relates to a fiber retention structure and a laser module, and more particularly to a fiber retention structure that retains an optical fiber to which a laser beam emitted from a laser device is coupled.

## Background Art

In a laser module, an optical fiber is generally inserted in a fiber retention hole of a ferrule and fixed therein by an adhesive material. A laser beam emitted from a laser device is focused to an end of the optical fiber (see, e.g., Patent Literature 1). A portion of the adhesive material used for fixing the optical fiber to the ferrule often spills from the fiber retention hole of the ferrule and solidifies therearound. Due to an increased power of a laser beam in recent years, a laser beam having a high power density that has not been coupled to the optical fiber may be incident on the adhesive material located around the fiber retention hole during alignment of the laser beam or operation of the laser module. Such a laser beam having a high power density may be absorbed by the adhesive material, which in turn generates heat to cause burnout of the optical fiber.

## Prior Art Literature

## Patent Literature

Patent Literature 1: JP 2018-155791 A

## Summary of the Invention

## Problem(s) to be Solved by the Invention

The present invention has been made in view of the above drawbacks in the prior art. It is, therefore, an object of the present invention to provide a fiber retention structure and a laser module that prevents heat generation due to light that has not been coupled to an optical fiber.

## Means for Solving Problem(s)

According to one aspect of the present invention, there is provided a fiber retention structure that prevents heat generation due to light that has not been coupled to an optical fiber. Specifically, a fiber retention structure according to Aspect 1 of the present invention comprises an optical fiber including a front end, a first fixation portion located behind the front end, and an intermediate portion located between the front end and the first fixation portion, a ferrule having a fiber retention hole formed therein for retaining the first fixation portion of the optical fiber, an adhesive material that fixes the first fixation portion of the optical fiber in the fiber retention hole of the ferrule, and a protection component surrounding the ferrule. The protection component includes a support portion covering a circumference of the ferrule and a shield portion covering a front surface of the ferrule and having a fiber insertion hole formed therein. The intermediate portion of the optical fiber is inserted in the fiber insertion hole.

According to Aspect 2 of the present invention, the fiber retention structure of Aspect 1 further comprises a flange retaining a second fixation portion of the optical fiber. The second fixation portion is located behind the first fixation portion. The support portion of the protection component is fixed to the flange.

According to Aspect 3 of the present invention, in the fiber retention structure of Aspect 1 or 2, a highly reflective coating layer having a high reflectance to light to be coupled to the front end of the optical fiber is formed on a front surface of the shield portion of the protection component.

According to Aspect 4 of the present invention, in the fiber retention structure of any one of Aspects 1 to 3, the protection component is formed of a material having a higher thermal conductivity than the optical fiber.

According to Aspect 5 of the present invention, in fiber retention structure of any one of Aspects 1 to 4, the fiber retention structure further comprises a cooling component having a higher thermal conductivity than the optical fiber. The cooling component is arranged in contact with the support portion of the protection component.

According to Aspect 6 of the present invention, in fiber retention structure of any one of Aspects 1 to 5, the intermediate portion of the optical fiber is held in contact with an inner surface of the fiber insertion hole in the shield portion of the protection component.

According to Aspect 7 of the present invention, in fiber retention structure of any one of Aspects 1 to 5, an air layer is formed between the intermediate portion of the optical fiber and an inner surface of the fiber insertion hole in the shield portion of the protection component.

According to another aspect of the present invention, there is provided a laser module that prevents heat generation due to light that has not been coupled to an optical fiber. Specifically, a laser module according to Aspect 8 of the present invention comprises a laser device operable to emit a laser beam, the fiber retention structure according to any one of Aspects 1 to 7, and a lens configured to couple the laser beam emitted from the laser device to the front end of the optical fiber in the fiber retention structure.

## Brief Description of Drawings

Fig. 1 is a partial cross-sectional view schematically showing a laser module according to a first embodiment of the present invention.

Fig. 2 is a cross-sectional view schematically showing the fiber retention structure in the laser module illustrated in Fig. 1.

Fig. 3 is a diagram schematically showing dimensions of primary portions of the fiber retention structure illustrated in Fig. 2.

Fig. 4 is a diagram schematically showing dimensions of primary portions of the fiber retention structure illustrated in Fig. 2.

Fig. 5 is a cross-sectional view schematically showing a variation of the fiber retention structure illustrated in Fig. 2.

Fig. 6 is a cross-sectional view schematically showing another variation of the fiber retention structure illustrated in Fig. 2.

Fig. 7 is a cross-sectional view schematically showing another variation of the fiber retention structure illustrated in Fig. 2.

**Mode(s) for Carrying Out the Invention**

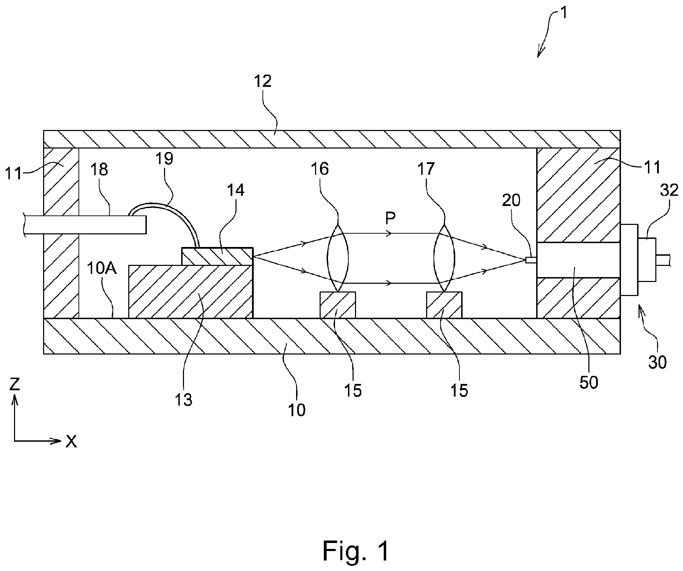

Embodiments of a fiber retention structure and a laser module according to the present invention will be described in detail below with reference to Figs. 1 to 7. In Figs. 1 to 7, the same or corresponding components are denoted by the same or corresponding reference numerals and will not be described below repetitively. Furthermore, in Figs. 1 to 7, the scales or dimensions of components may be exaggerated, and some components may be omitted. Unless mentioned otherwise, in the following description, terms such as "first," "second," and so forth are only used to distinguish one component from another and are not used to indicate a specific order or a specific sequence.

Fig. 1 is a partial cross-sectional view schematically showing a laser module 1 according to a first embodiment of the present invention. As shown in Fig. 1, the laser module 1 of the present embodiment has a bottom plate 10, side walls 11 fixed on an upper surface 10A of the bottom plate 10, a cover plate 12 placed on upper portions of the side walls 11, a submount 13 disposed on the upper surface 10A of the bottom plate 10, a high-power semiconductor laser device 14 placed on the submount 13, lenses 16 and 17 disposed on lens mounts 15 arranged on the upper surface 10A of the bottom plate 10, and a fiber retention structure 30 including an optical fiber 20 that allows a laser beam P emitted from the semiconductor laser device 14 to propagate to an exterior of the laser module 1. For example, a high-power laser diode having several W to 20 W may be used for the laser device 14. Although not illustrated in the drawings, a heat sink is connected to a bottom surface of the bottom plate 10. For the sake of convenience, - X-direction in Fig. 1 is referred to as "front" or "ahead," and + X-direction is referred to as "rear" or "behind" in the present embodiment.

As shown in Fig. 1, the fiber retention structure 30 is provided so as to penetrate through one of the side walls 11. Leads 18 are provided so as to penetrate through another one of the side walls 11. The leads 18 are connected to the laser device 14 through bonding wires 19. With this configuration, electric power is supplied to the laser device 14 through the leads 18 and the bonding wires 19 to emit a laser beam P from the laser device 14 in + X-direction.

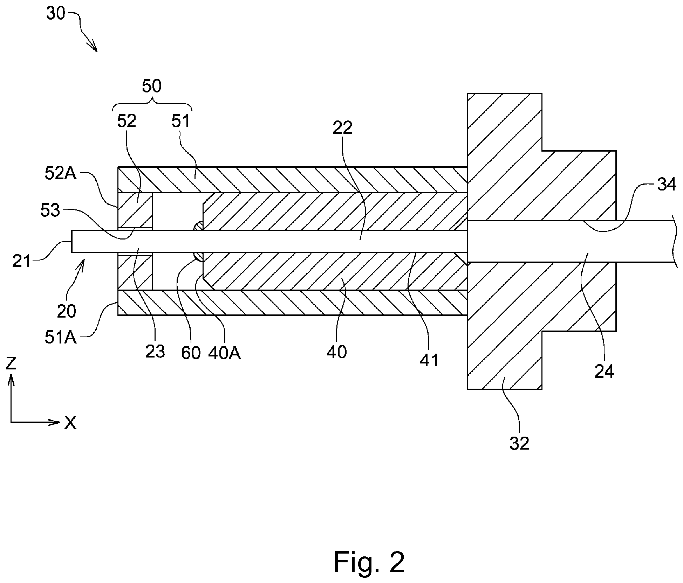

Fig. 2 is a cross-sectional view schematically showing the fiber retention structure 30. As shown in Fig. 2, the fiber retention structure 30 includes the optical fiber 20, a ferrule 40 that holds the optical fiber 20, a protection component 50 surrounding the ferrule 40, and a flange 32 attached to the side wall 11 of the laser module 1. The optical fiber 20 has a front end 21, which is arranged at such a location that the laser beam P that has been emitted from the semiconductor laser device 14 and focused by the lens 17 is optically coupled to the front end 21. The optical fiber 20 includes a core, a cladding surrounding an outer circumference of the core and having a refractive index lower than a refractive index of the core, a covering surrounding an outer circumference of the cladding and having a refractive index lower than the refractive index of the cladding. The covering has been removed in an area located ahead of the flange 32, where the cladding is exposed.

For example, the ferrule 40 is a generally cylindrical member formed of zirconia. The ferrule 40 has a fiber retention hole 41 extending therethrough along the X-direction at the center of the ferrule 40. A first fixation portion 22 of the optical fiber 20, which is located behind the front end 21, is retained in the fiber retention hole 41. The first fixation portion 22 of the optical fiber 20 is fixed within the fiber retention hole 41 by an adhesive material 60, which has been filled in the fiber retention hole 41 of the ferrule 40. As shown in Fig. 2, a portion of the adhesive material 60 has spilled over a front surface 40A of the ferrule 40 from the fiber retention hole 41 and solidified therearound.

The protection component 50 includes a cylindrical support portion 51 that surrounds an outer circumference of the ferrule 40 and a disc-like shield portion 52 that covers the front surface 40A of the ferrule 40. The support portion 51 and the shield portion 52 may be formed as separate members. Alternatively, the support portion 51 and the shield portion 52 may be formed integrally with each other. The shield portion 52 has a fiber insertion hole 53 formed at the center thereof for allowing an intermediate portion 23 of the optical fiber 20, which is located between the front end 21 and the first fixation portion 22, to be inserted thereto. The support portion 51 of the protection component 50 may be fixed on an outer circumferential surface of the ferrule 40 by an adhesive material (not shown) or fixed on an outer circumferential surface of the ferrule 40 by being fit onto the outer circumferential surface of the ferrule 40.

The flange 32 has a through hole 34 extending therethrough along the X-direction at the center of the flange 32. A second fixation portion 24 of the optical fiber 20, which is located behind the first fixation portion 22, is retained in the through hole 34. The support portion 51 of the protection component 50 may be fixed to the flange 32. When the support portion 51 of the protection component 50 is thus fixed to the flange 32, the first fixation portion 22 of the optical fiber 20 is fixed to the flange 32 via the ferrule 40 and the support portion 51 of the protection component 50, and the second fixation portion 24 of the optical fiber 20 is retained in the flange 32. Therefore, the optical fiber 20 can be retained in a more stable manner. For example, the support portion 51 of the protection component 50 may be fixed to the flange 32 by press fitting or fixed to the flange 32 by use of an adhesive material. If an adhesive material is used to fix the support portion 51 of the protection component 50 to the flange 32, the adhesive material may move between the support portion 51 of the protection component 50 and an outer circumferential surface of the ferrule 40 due to a capillary phenomenon, leaking out onto the front surface 40A of the ferrule 40. In such a case, light that has not been coupled to the core at the front end 21 of the optical fiber 20 propagates rearward and may be incident on the adhesive material, which may in turn generate heat. In this regard, use of press fitting to fix the support portion 51 of the protection component 50 to the flange 32 can eliminate a cause of such heat generation. The cladding is covered with the covering in the second fixation portion 24 of the optical fiber 20 while the cladding is exposed in the first fixation portion 22, the intermediate portion 23, and the front end 21.

The optical fiber 20 extends forward from the shield portion 52 of the protection component 50. The front end 21 of the optical fiber 20 is located ahead of the shield portion 52 of the protection component 50. The intermediate portion 23 of the optical fiber 20, which is inserted to the fiber insertion hole 53 in the shield portion 52 of the protection component 50, may be held in contact with an inner circumferential surface of the fiber insertion hole 53 or may be spaced from the inner circumferential surface of the fiber insertion hole 53. Fig. 2 shows an example in which the intermediate portion 23 of the optical fiber 20 is spaced from the inner circumferential surface of the fiber insertion hole 53.

In this manner, according to the present embodiment, the ferrule 40 is covered with the protection component 50, and the shield portion 52 of the protection component 50 is located between the front surface 40A of the ferrule 40 and the front end 21 of the optical fiber 20. Thus, the laser beam P that has not been coupled to the front end 21 of the optical fiber 20 is shielded by the shield portion 52 of the protection component 50 and is unlikely to reach the adhesive material 60 that is located around the fiber retention hole 41 in the front surface 40A of the ferrule 40. Therefore, the amount of the laser beam P incident on the adhesive material 60 can be decreased. Accordingly, the adhesive material 60 is prevented from absorbing the laser beam P and generating heat to cause burnout of the optical fiber 20.

Now conditions under which no laser beam P is incident on the adhesive material 60 around the fiber retention hole 41 of the ferrule 40 are examined. According to Snell's law at the front end 21 of the optical fiber 20, a numerical aperture NA of the optical fiber 20 is given by the following expression (1):

$$\mathrm{NA} = n \cdot \sin \theta \quad \cdots (1)$$

where $\theta$ is the maximum acceptance angle of the optical fiber 20 and n is a refractive index of a medium (air) existing between the optical fiber 20 and the lens 17.

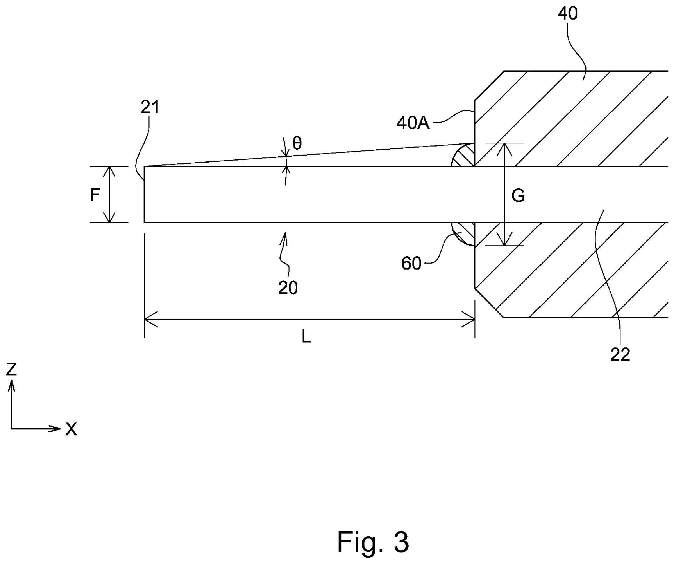

The laser beam P that propagates with an angle that exceeds the maximum acceptance angle $\theta$ of the optical fiber 20 is not coupled to the core on the front end 21 of the optical fiber 20, so that it propagates rearward. As shown in Fig. 3, the conditions under which this laser beam P is not incident on the adhesive material 60 fixed around the fiber retention hole 41 of the ferrule 40 are expressed by the following expression (2):

$$G < F + 2 \times L \tan \theta \quad \cdots (2)$$

where $F$ is a diameter of the front end 21 of the optical fiber 20, G is a diameter of the adhesive material 60 around the fiber retention hole 41 of the ferrule 40, and L is a distance from the front surface 40A of the ferrule 40 to the front end 21 of the optical fiber 20.

Because the medium existing between the optical fiber 20 and the lens 17 is air, we assume that n = 1. The following expression (3) is derived from the above expressions (1) and (2).

$$L > (G - F)/(2 \times \tan(\mathrm{asin}(\mathrm{NA}))) \quad \cdots (3)$$

Therefore, when the distance L from the front surface 40A of the ferrule 40 to the front end 21 of the optical fiber 20 is made greater than (G - F)/(2 × tan(asin(NA))), the laser beam P is prevented from being incident on the adhesive material 60. As an example, we assume that NA of the optical fiber 20 is 0.22, that the diameter F of the front end 21 of the optical fiber 20 is 125 μm, and that the diameter G of the adhesive material 60 around the fiber retention hole 41 of the ferrule 40 is 500 μm. As asin(0.22) = 12.7°, the following expressions are derived from the expression (2):

$$L > (500 \ \mu\mathrm{m} - 125 \ \mu\mathrm{m})/(2 \times \tan(12.7°))$$

$$L > 832 \ \mu\text{m}$$

Thus, when the distance L from the front surface 40A of the ferrule 40 to the front end 21 of the optical fiber 20 is greater than 832 μm, the laser beam P is prevented from being incident on the adhesive material 60.

For example, the front end 21 of the optical fiber 20 is formed by a section with laser cleaving. For example, an antireflective firm for suppressing reflection of light having a wavelength range of the laser beam P may be formed on the front end 21 of the optical fiber 20 so that the laser beam P can efficiently be coupled to the front end 21 of the optical fiber 20.

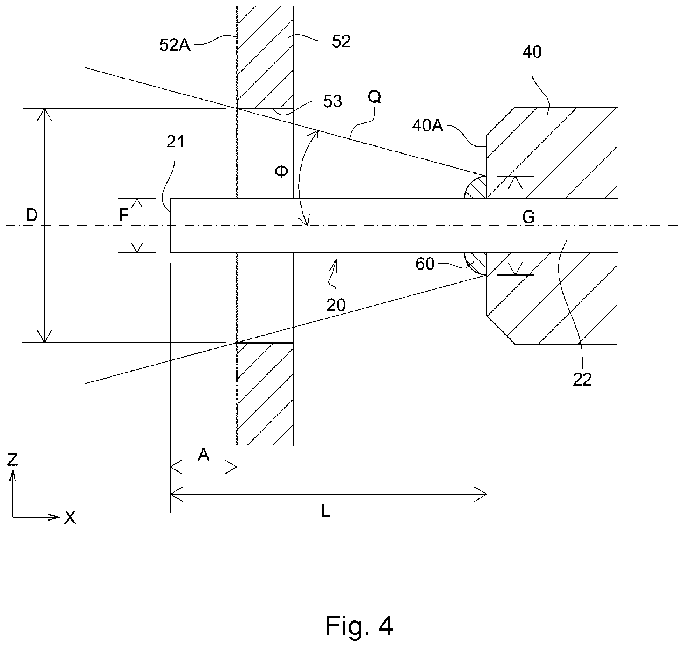

If an inside diameter of the fiber insertion hole 53 in the shield portion 52 increases, a laser beam may be incident on the adhesive material 60 to cause the adhesive material 60 to generate heat, particularly at the time of alignment of the laser beam. Therefore, conditions for the inside diameter of the fiber insertion hole 53 under which no laser beam is incident on the adhesive material 60 are examined. As shown in Fig. 4, the conditions under which no laser beam Q is incident on any area of the adhesive material 60 are expressed by the following expression (4):

$$\tan \varphi > \frac{\left(\frac{D}{2} - \frac{G}{2}\right)}{L - A} \quad \cdots (4)$$

where $D$ is an inside diameter of the fiber insertion hole 53 in the shield portion 52, $A$ is a distance along the X-direction from the front surface 52A of the shield portion 52 to the front end 21 of the optical fiber 20, and $\varphi$ is a half angle of the laser beam Q with respect to the optical axis of the optical fiber 20.

The expression (4) is equivalent to the following expression (5):

$$D < 2(L - A)\tan \varphi + G \cdots (5)$$

Therefore, when the inside diameter $D$ of the fiber insertion hole 53 in the shield portion 52 meets the following expression (6), the laser beam Q becomes unlikely to be incident on the adhesive material 60.

$$F < D < 2(L - A)\tan \varphi + G \qquad \cdots (6)$$

As an example, we assume that the diameter $F$ of the front end 21 of the optical fiber 20 is 125 μm, that the distance $L$ from the front surface 40A of the ferrule 40 to the front end 21 of the optical fiber 20 is 2 mm, that the distance $A$ along the X-direction from the front surface 52A of the shield portion 52 to the front end 21 of the optical fiber 20 is 500 μm, that the half angle $\varphi$ of the laser beam Q with respect to the optical axis of the optical fiber 20 is 12.7°, and that the diameter $G$ of the adhesive material 60 around the fiber retention hole 41 of the ferrule 40 is 500 μm. Then the following expression is derived from the expression (6):

$$125 \ \mu\text{m} < D < 1.63 \ \text{mm}$$

When $D$ is within the above range, for example, $D$ = 0.5 mm, the amount of laser beam passing through the fiber insertion hole 53 of the shield portion 52 is calculated, from a ratio of areas on which the laser beam is incident, to be about 1/10 of a case where $D$ = 1.63 mm. Thus, when $D$ is within the above range, the laser beam is prevented from being incident directly on the adhesive material 60. Accordingly, the provision of the shield portion 52 reduces the power density of the laser beam incident on the adhesive material 60 as compared to the conventional fiber retention structure.

In the example illustrated in Fig. 2, the front end 21 of the optical fiber 20 is positioned ahead of the shield portion 52 of the protection component 50. However, the front end 21 of the optical fiber 20 may be aligned with (flush with) the front surface 52A of the shield portion 52 of the protection component 50 in the X-direction. Alternatively, the front end 21 of the optical fiber 20 may be positioned within the fiber insertion hole 53 but behind the front surface 52A of the shield portion 52 of the protection component 50. When the front end 21 of the optical fiber 20 is flush with or positioned behind the front surface 52A of the shield portion 52 of the protection component 50, an accidental contact with the front end 21 of the optical fiber 20 is prevented during handling of the laser module 1, making the optical fiber 20 less likely to break.

In the example illustrated in Fig. 2, the intermediate portion 23 of the optical fiber 20 is spaced from the inner circumferential surface of the fiber insertion hole 53. However, as described above, the intermediate portion 23 of the optical fiber 20 may be held in contact with the inner circumferential surface of the fiber insertion hole 53. If the shield portion 52 of the protection component 50 has a refractive index higher than that of the cladding of the optical fiber 20, the laser beam P that has leaked into the cladding instead of being confined in the core of the optical fiber 20 may leak into the shield portion 52 of the protection component 50 when the intermediate portion 23 of the optical fiber 20 is held in contact with the inner circumferential surface of the fiber insertion hole 53. Accordingly, the amount of the laser beam P that reaches the aforementioned adhesive material 60 around the fiber retention hole 41 of the ferrule 40 can be reduced.

In this regard, in the example illustrated in Fig. 2, an air layer exists between the intermediate portion 23 of the optical fiber 20 and the inner circumferential surface of the fiber insertion hole 53 in the shield portion 52 of the protection component 50. Therefore, the laser beam P that has leaked into the cladding instead of being confined in the core of the optical fiber 20 remains confined in the cladding as it propagates downstream. When an adhesive material having a refractive index lower than that of the cladding of the optical fiber 20 is used as the adhesive material 60 for fixing the optical fiber 20, the laser beam P that has leaked into the cladding is prevented from leaking into the adhesive material 60 that has spilled from the fiber retention hole 41 of the ferrule 40.

Furthermore, a highly reflective coating layer having a high reflectance to light having a wavelength range of the laser beam P may be formed on the front surface 52A of the shield portion 52 of the protection component 50. Moreover, a highly reflective coating layer may also be formed on a front face 51A of the support portion 51 in addition to the front surface 52A of the shield portion 52 of the protection component 50. When those highly reflective coating layers are formed, a portion of the laser beam P that has not been coupled to the front end 21 of the optical fiber 20 can be reflected by the highly reflective coating layers of the shield portion 52 and the support portion 51. Therefore, the possibility that the laser beam P that has not been coupled to the front end 21 of the optical fiber 20 reaches the adhesive material 60 around the fiber retention hole 41 can be further reduced.

When the support portion 51 and the shield portion 52 of the protection component 50 are formed as separate members, the shield portion 52 may be made of, for example, silica glass, sapphire, ceramic, or metal. The support portion 51 may be made of a material that absorbs the laser beam P more efficiently than the optical fiber 20 and has a high thermal conductivity, such as a metal like copper or aluminum. When the support portion 51 and the shield portion 52 of the protection component 50 are formed integrally with each other, it is preferable to make the protection component 50 of a material that absorbs the laser beam P more efficiently than the optical fiber 20 and has a high thermal conductivity, such as a metal like copper or aluminum. The protection component 50 (the support portion 51) may preferably have a higher thermal conductivity than the optical fiber 20 and preferably have a higher thermal conductivity than the ferrule 40. In this manner, when the protection component 50 (support portion 51) is formed of a material having a higher thermal conductivity than the optical fiber 20 and the ferrule 40, heat generated in the optical fiber 20 or the ferrule 40 by the laser beam P can readily be dissipated to an exterior of the laser module via the protection component 50. Furthermore, the protection component 50 may be formed integrally with the side wall 11 of the laser module 1 (Fig. 1).

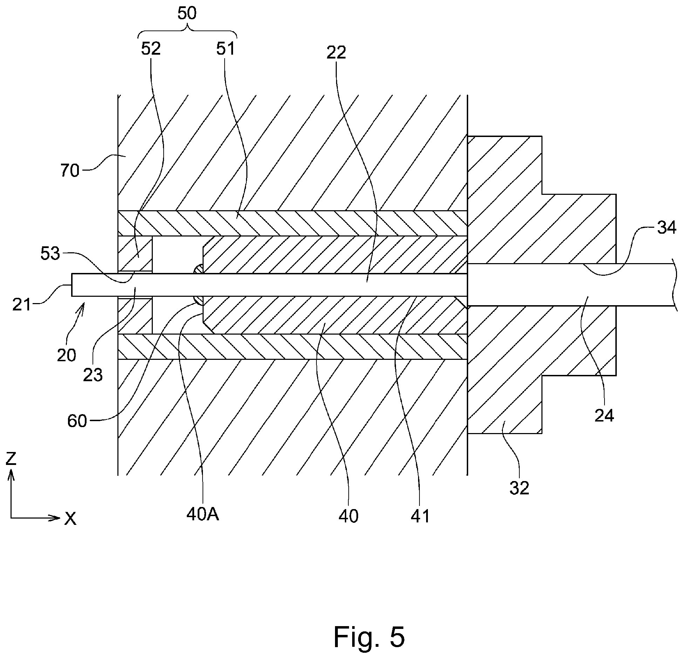

As shown in Fig. 5, a cooling component 70 having a higher thermal conductivity than the optical fiber 20 may be arranged in contact with the support portion 51 of the protection component 50. For example, the cooling component 70 may be formed of a metal such as copper or aluminum. The cooling component 70 may have fins for heat dissipation. With the cooling component 70 thus arranged, heat generated in the optical fiber 20, the ferrule 40, or the protection component 50 can readily be dissipated to an exterior of the laser module via the cooling component 70. Furthermore, the cooling component 70 may be formed integrally with the side wall(s) 11 of the laser module 1 (Fig. 1).

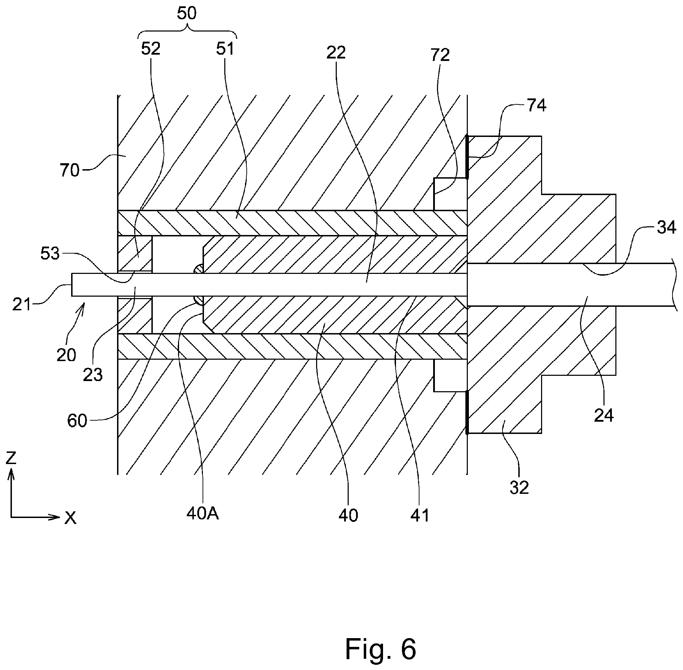

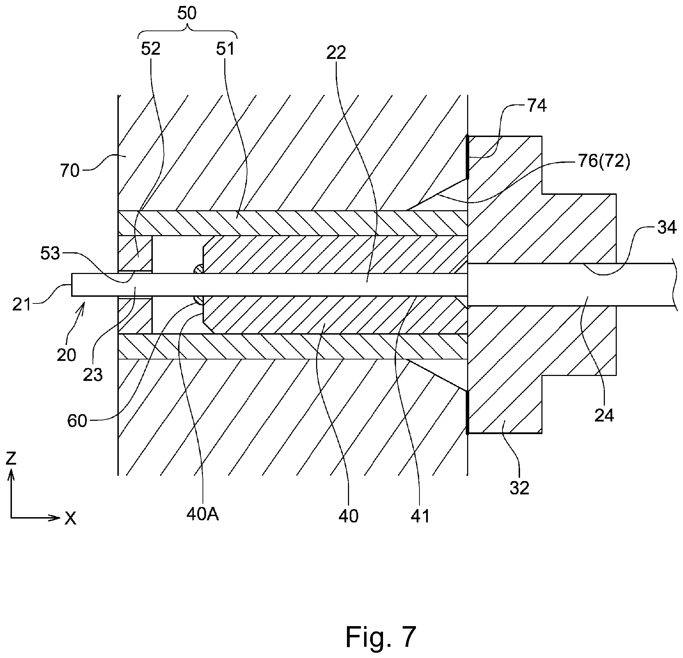

In this case, an adhesive material may be applied to between the cooling component 70 and the flange 32, so that the cooling component 70 and the flange 32 are fixed to each other by the adhesive material. In such a case, as shown in Fig. 6, a recess 72 may be formed around the support portion 51 of the protection component 50 on an end face of the cooling component 70 near the flange 32. With such a recess 72, the adhesive material 74 for fixing the cooling component 70 and the flange 32 can be located away from the optical fiber 20 and the ferrule 40. Therefore, the adhesive material 74 is unlikely to leak into a space where the laser beam P propagates. Accordingly, the laser beam P is prevented from being incident on the adhesive material 74 to generate heat in the adhesive material 74, resulting in an improved reliability of the laser module 1. The recess 72 may be formed by an inclined surface 76 as illustrated in Fig. 7.

The terms "front," "ahead," "rear," "behind," and other positional terms described herein are only used to specify relative relationships between components in connection with the illustrated embodiments and are not used to specify absolute relationships between them. Therefore, it should be noted that directions referred to by those terms vary when the position or posture of the apparatus changes.

As described above, according to a first aspect of the present invention, there is provided a fiber retention structure that can prevent heat generation due to light that has not been coupled to an optical fiber. Specifically, a fiber retention structure according to the present invention can adopt the following configurations:

(Configuration 1)

A fiber retention structure comprises an optical fiber including a front end, a first fixation portion located behind the front end, and an intermediate portion located between the front end and the first fixation portion, a ferrule having a fiber retention hole formed therein for retaining the first fixation portion of the optical fiber, an adhesive material that fixes the first fixation portion of the optical fiber in the fiber retention hole of the ferrule, and a protection component surrounding the ferrule. The protection component includes a support portion covering a circumference of the ferrule and a shield portion covering a front surface of the ferrule and having a fiber insertion hole formed therein. The intermediate portion of the optical fiber is inserted in the fiber insertion hole.

In this manner, the ferrule is covered with the protection component, and the shield portion of the protection component is located between the front surface of the ferrule and the front end of the optical fiber. Thus, light that has not been coupled to the front end of the optical fiber is shielded by the shield portion of the protection component and is unlikely to reach the adhesive material that is located around the fiber retention hole in the front surface of the ferrule. Therefore, the amount of the laser beam incident on the adhesive material can be decreased. Accordingly, the adhesive material is prevented from absorbing the laser beam and generating heat to cause burnout of the optical fiber.

(Configuration 2)

In Configuration 1, the fiber retention structure may further comprise a flange retaining a second fixation portion of the optical fiber. The second fixation portion is located behind the first fixation portion. The support portion of the protection component is fixed to the flange. With this configuration, the first fixation portion of the optical fiber is fixed to the flange via the ferrule and the support portion of the protection component, and the second fixation portion is retained in the flange. Therefore, the optical fiber can be retained in a more stable manner.

(Configuration 3)

In Configuration 1 or 2, a highly reflective coating layer having a high reflectance to light to be coupled to the front end of the optical fiber may be formed on a front surface of the shield portion of the protection component. When such a highly reflective coating layer is formed, a portion of the laser beam that has not been coupled to the front end of the optical fiber can be reflected by the highly reflective coating layer of the shield portion. Therefore, the possibility that the laser beam that has not been coupled to the front end of the optical fiber reaches the adhesive material around the fiber retention hole can be further reduced.

(Configuration 4)

In any one of Configurations 1 to 3, the protection component may be formed of a material having a higher thermal conductivity than the optical fiber. When the protection component is thus formed of a material having a higher thermal conductivity than the optical fiber, heat generated in the optical fiber or the ferrule can readily be dissipated to an exterior of the laser module via the protection component.

(Configuration 5)

In any one of Configurations 1 to 4, the fiber retention structure may further comprise a cooling component having a higher thermal conductivity than the optical fiber. The cooling component is arranged in contact with the support portion of the protection component. With the cooling component thus arranged, heat generated in the optical fiber, the ferrule, or the protection component can readily be dissipated to an exterior of the laser module via the cooling component.

(Configuration 6)

In any one of Configurations 1 to 5, the intermediate portion of the optical fiber may be held in contact with an inner surface of the fiber insertion hole in the shield portion of the protection component.

(Configuration 7)

In any one of Configurations 1 to 5, an air layer may be formed between the intermediate portion of the optical fiber and an inner surface of the fiber insertion hole in the shield portion of the protection component.

(Configuration 8)

According to a second aspect of the present invention, there is provided a laser module that prevents heat generation due to a laser beam that has not been coupled to an optical fiber. This laser module comprises a laser device operable to emit a laser beam, the fiber retention structure according to any one of Configurations 1 to 7, and a lens configured to couple the laser beam emitted from the laser device to the front end of the optical fiber in the fiber retention structure.

Although some preferred embodiments of the present invention have been described, the present invention is not limited to the aforementioned embodiments. As a matter of course, therefore, the present invention may be implemented in various different ways within the technical idea thereof.

This application claims the benefit of priority from Japanese patent application No. 2022-176000, filed on November 2, 2022 the disclosure of which is incorporated herein in its entirety by reference.

**Industrial Applicability**

The present invention is suitably used for a fiber retention structure that retains an optical fiber to which a laser beam emitted from a laser device is coupled.

**Description of Reference Numerals and Signs**

1        Laser module

10        Bottom plate
11        Side wall
12        Cover plate
13        Submount
14        Laser device
16, 17        Lens
20        Optical fiber
21        Front end
22        First fixation portion
23        Intermediate portion

| 24 | Second fixation portion |
|---|---|
| 30 | Fiber retention structure |
| 32 | Flange |
| 34 | Through hole |
| 40 | Ferrule |
| 40A | Front surface |
| 41 | Fiber retention hole |
| 50 | Protection component |
| 51 | Support portion |
| 52 | Shield portion |
| 53 | Fiber insertion hole |
| 60 | Adhesive material |
| 70 | Cooling component |
| 72 | Recess |

**Claims**

1. A fiber retention structure comprising:

   an optical fiber including a front end, a first fixation portion located behind the front end, and an intermediate portion located between the front end and the first fixation portion;
   a ferrule having a fiber retention hole formed therein for retaining the first fixation portion of the optical fiber;
   an adhesive material that fixes the first fixation portion of the optical fiber in the fiber retention hole of the ferrule; and
   a protection component surrounding the ferrule, the protection component including:

   a support portion covering a circumference of the ferrule, and
   a shield portion covering a front surface of the ferrule and having a fiber insertion hole formed therein, the intermediate portion of the optical fiber being inserted in the fiber insertion hole.

2. The fiber retention structure as recited in claim 1, further comprising a flange holding a second fixation portion of the optical fiber, the second fixation portion being located behind the first fixation portion, wherein the support portion of the protection component is fixed to the flange.

3. The fiber retention structure as recited in claim 1, wherein a highly reflective coating layer having a high reflectance to light to be coupled to the front end of the optical fiber is formed on a front surface of the shield portion of the protection component.

4. The fiber retention structure as recited in claim 1, wherein the protection component is formed of a material having a higher thermal conductivity than the optical fiber.

5. The fiber retention structure as recited in claim 1, further comprising a cooling component having a higher thermal conductivity than the optical fiber, the cooling component being arranged in contact with the support portion of the protection component.

6. The fiber retention structure as recited in claim 1, wherein the intermediate portion of the optical fiber is held in contact with an inner surface of the fiber insertion hole in the shield portion of the protection component.

7. The fiber retention structure as recited in claim 1, wherein an air layer is formed between the intermediate portion of the optical fiber and an inner surface of the fiber insertion hole in the shield portion of the protection component.

8. A laser module comprising:

   a laser device operable to emit a laser beam;
   the fiber retention structure as recited in any one of claims 1 to 7; and
   a lens configured to couple the laser beam emitted from the laser device to the front end of the optical fiber in the fiber retention structure.

Fig. 1

Fig. 2

Fig. 3

Fig. 4

Fig. 5

Fig. 6

Fig. 7

## INTERNATIONAL SEARCH REPORT

| International application No. |
|---|
| **PCT/JP2023/029219** |

| A. | CLASSIFICATION OF SUBJECT MATTER |
|---|---|

*G02B 6/46*(2006.01)i; *G02B 6/42*(2006.01)i; *H01S 5/02251*(2021.01)i; *H01S 5/02326*(2021.01)i
FI: G02B6/46; G02B6/42; H01S5/02251; H01S5/02326

According to International Patent Classification (IPC) or to both national classification and IPC

| B. | FIELDS SEARCHED |
|---|---|

Minimum documentation searched (classification system followed by classification symbols)

G02B6/42; G02B6/46; H01S5/02251; H01S5/02326

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2015/037725 A1 (THE FURUKAWA ELECTRIC CO., LTD.) 19 March 2015 (2015-03-19)<br>paragraphs [0031]-[0052], [0084], fig. 1-3 | 1-8 |
| Y | JP 2003-107294 A (MITSUBISHI CABLE IND LTD.) 09 April 2003 (2003-04-09)<br>paragraphs [0024]-[0033], fig. 1 | 1-8 |
| Y | JP 2006-184337 A (KYOCERA CORP.) 13 July 2006 (2006-07-13)<br>paragraphs [0049], [0050], fig. 3(a)-4(a) | 2, 8 |
| A | JP 2016-533543 A (OPTOSKAND AB) 27 October 2016 (2016-10-27)<br>entire text, all drawings | 1-8 |
| A | JP 2015-518185 A (IPG PHOTONICS CORP.) 25 June 2015 (2015-06-25)<br>entire text, all drawings | 1-8 |
| A | JP 2007-293298 A (THE FURUKAWA ELECTRIC CO., LTD.) 08 November 2007 (2007-11-08)<br>entire text, all drawings | 1-8 |

| ✓ | Further documents are listed in the continuation of Box C. | ✓ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 October 2023** | **17 October 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/029219**

| C. | DOCUMENTS CONSIDERED TO BE RELEVANT | |
|---|---|---|
| Category* | Citation of document, with indication, where appropriate, of the relevant passages | Relevant to claim No. |
| A | US 2020/0200363 A1 (SORAA LASER DIODE, INC.) 25 June 2020 (2020-06-25) fig. 15 | 8 |

Form PCT/ISA/210 (second sheet) (January 2015)

## INTERNATIONAL SEARCH REPORT
### Information on patent family members

International application No.

**PCT/JP2023/029219**

| Patent document cited in search report | | | Publication date (day/month/year) | Patent family member(s) | | | Publication date (day/month/year) |
|---|---|---|---|---|---|---|---|
| WO | 2015/037725 | A1 | 19 March 2015 | US | 2016/0246022 | A1 | |
| | | | | paragraphs [0026]-[0051], [0086], fig. 1-3 | | | |
| | | | | US | 2017/0315311 | A1 | |
| | | | | EP | 3045947 | A1 | |
| | | | | CN | 105518505 | A | |
| JP | 2003-107294 | A | 09 April 2003 | (Family: none) | | | |
| JP | 2006-184337 | A | 13 July 2006 | (Family: none) | | | |
| JP | 2016-533543 | A | 27 October 2016 | US | 2016/0259140 | A1 | |
| | | | | WO | 2015/057125 | A1 | |
| | | | | EP | 3058405 | A1 | |
| | | | | KR | 10-2016-0072238 | A | |
| | | | | CN | 105659133 | A | |
| | | | | SE | 1330130 | A1 | |
| JP | 2015-518185 | A | 25 June 2015 | WO | 2013/181183 | A1 | |
| | | | | EP | 2856584 | A1 | |
| | | | | EP | 3640691 | A2 | |
| | | | | CN | 104521077 | A | |
| | | | | KR | 10-2015-0023460 | A | |
| JP | 2007-293298 | A | 08 November 2007 | US | 2009/0092358 | A1 | |
| | | | | WO | 2007/116792 | A1 | |
| | | | | EP | 2009473 | A1 | |
| US | 2020/0200363 | A1 | 25 June 2020 | US | 2022/0364699 | A1 | |
| | | | | WO | 2020/132692 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018155791 A

- JP 2022176000 A